# EUROPEAN PATENT SPECIFICATION

(11) **EP 4 293 902 B1**
(45) Date of publication and mention of the grant of the patent: **16.09.2026**
(21) Application number: 22305870.2
(22) Date of filing: 14.06.2022
(51) Int. Cl.: H03F 3/181, H03G 3/00, H03G 3/30

(54) **A METHOD AND DEVICE FOR LIMITING POWER TO PROTECT POWER SUPPLY FROM OVERLOAD IN A MULTICHANNEL AUDIO AMPLIFIER**
VERFAHREN UND VORRICHTUNG ZUR LEISTUNGSBEGRENZUNG ZUM SCHUTZ DER STROMVERSORGUNG VOR ÜBERLAST IN EINEM MEHRKANALIGEN AUDIOVERSTÄRKER
PROCÉDÉ ET DISPOSITIF POUR LIMITER LA PUISSANCE AFIN DE PROTÉGER L'ALIMENTATION D'UNE SURCHARGE DANS UN AMPLIFICATEUR AUDIO MULTICANAL

(43) Date of publication of application: 20.12.2023
(73) Proprietor: L-Acoustics, 91462 Marcoussis Cedex (FR)
(72) Inventor: WEGNER, Carsten, 57074 Siegensand (DE)
(74) Representative: Novagraaf Technologies

(56) References cited:
- KR-A- 20200 129 151

## Description

### TECHNICAL FIELD

Various example embodiments relate generally to a method and device for use in an audio system including a plurality of amplifier channels.

### BACKGROUND

In present audio systems the number of audio channels is continuously increasing. Starting with 2-channel stereo, now 5+1 or even 7+1 surround amplifiers are common. Modern line array loudspeaker systems can use 48 channels. For best performance as well as for scientific purposes, there are wave field synthesis arrays with up to 832 independent channels. Because of size and cost reasons, it makes sense to connect many amplifier channels to only one power supply. Because not all channels are driven with their maximum power capability at the same time, the average power of the channels determines the long-term power capability of the common power supply.

An audio signal may represent for example a musical content. Since musical content is dynamic, rating the power supply for the maximum instantaneous power would be both expensive and unnecessary. During power peaks, the energy is provided by one or more bulk capacitors. The state of charge of these bulk capacitors depends on the history of power demand (e.g., whether the bulk capacitors are depleted by a previous power draw, or whether they had time to recharge during a quiet part of the audio signal).

To avoid switch-off, a typical solution is to limit the root mean square (RMS) level of the audio signal to be amplified, using a dynamic range compressor or limiter. Because the impedance of the load is frequency dependent, and partly reactive, the relationship between the output signal level and the output power is not trivial. Thus, to prevent amplifier switch-off, the limiter would need to be set conservatively, potentially not exploiting the full output power capability of the system. In addition, by using such a limiter operating independently on each audio channel, the multichannel advantage of a shared power supply described above is not obtained.

In a multichannel amplifier, it is common that the power supply and the bulk capacitor(s) are shared between the different amplification channels. If the power supply is accidentally overloaded, a protection mechanism switches off the circuit to prevent damages.

There is a need for a limiting device that takes the power demand of all amplification channels into account while minimizing audible distortion and preventing switch-off of the power supply.
KR 2020 0129151 A concerns a system for limiting amplifier input current to avoid low voltage conditions. The system is a predictive brownout prevention system that relies on a control state machine 140 that receives inputs from a voltage monitor 122, a battery impedance monitor 124 and a supply response predictor 126.

### SUMMARY

The scope of protection is set out by the independent claims. The embodiments, examples and features, if any, described in this specification that do not fall under the scope of the protection are to be interpreted as examples useful for understanding the various embodiments or examples that fall under the scope of protection.

According to a first aspect a device for use in an audio system including a plurality of amplifier channels of corresponding audio channels is disclosed. Each of the amplifier channels receiving a respective input audio signal and being powered by a same power supply, the device comprising means for performing a method comprising: obtaining a value of an indicator, wherein the indicator is representative of an energy reserve of the power supply; for each of the amplifier channels, determining a gain to be applied by an attenuation function to the respective input audio signal and a clipping level to be applied by a clipping function to the output of the attenuation function; wherein the gain decreases over time when the value of the indicator is below a threshold and the gain increases over time up to a maximum value when the value of the indicator is above the threshold, wherein the threshold is representative of a nominal energy level at which the power supply is in nominal operation; wherein the clipping level is determined as a monotonic function of the value of the indicator.

The gain may decrease over time by an attack rate. The attack rate may be a fixed attack rate that corresponds to a fixed gain decrease per time period on a logarithmic scale. The attack rate may be a dynamic attack rate computed as a function of the value of the indicator. The gain may increase over time by a release rate. The release rate is a fixed release rate that corresponds to a fixed gain increase per time period on a logarithmic scale. When the value of the indicator is below the threshold, the clipping level may be determined by applying a monotonic function of an output voltage of the power supply. The monotonic function may be a linear function of the output voltage of the power supply.

The indicator may be proportional to the output voltage of the power supply or to the squared output voltage of the power supply. The indicator may be proportional to the stored energy in the power supply. The gain varies between a minimum value and the maximum value. The monotonic function may be adjusted based on mains voltage level signal received from the power supply.

The means may comprise for each amplifier channel: a clipping device connected to the input of the amplifier channel and configured to apply the clipping function; an attenuation device whose output is connected to the input of the clipping device, wherein the attenuation device is configured to apply the attenuation function.

According to a second aspect, disclosed is a method for use in an audio system including a plurality of amplifier channels of corresponding audio channels, each of the amplifier channels receiving a respective input audio signal and being powered by a same power supply, the method comprising: obtaining a value of an indicator, wherein the indicator is representative of an energy reserve of the power supply; for each of the amplifier channels, determining a gain to be applied by an attenuation function to the respective input audio signal and a clipping level to be applied by a clipping function to the output of the attenuation function; wherein the gain decreases over time when the value of the indicator is below a threshold and the gain increases over time up to a maximum value when the value of the indicator is above the threshold, wherein the threshold is representative of a nominal energy level at which the power supply is in nominal operation; wherein the clipping level is determined as a monotonic function of the value of the indicator.

According to another aspect disclosed is a computer program comprising instructions that, when executed by at least one processor, causes a device to perform a method according to the second aspect.

### BRIEF DESCRIPTION OF THE DRAWINGS

Example embodiments will become more fully understood from the detailed description given herein below and the accompanying drawings, which are given by way of illustration only and thus are not limiting of this disclosure.
**FIG. 1** is a schematic block diagram of a multichannel amplifying system with a power supply that delivers power to several amplifier channels with full bridge output stages driving bridge tied loads.
**FIG. 2** is a schematic block diagram of a multichannel amplifying system with a power supply having two symmetric supply voltages that delivers power to several amplifier channels with half bridge output stages driving single ended loads.
**FIG. 3** is a schematic block diagram of a multichannel amplifying system including a limiting device according to an example with full bridge output stages driving bridge tied loads.
**FIG. 4** is a schematic block diagram of a multichannel amplifying system including a limiting device according to an example with half bridge output stages driving single ended loads.
**FIG. 5A** shows the variations of the gain applied by an attenuation device over time for a fixed attack rate (*AR*)*,* a maximum gain (*MG*) at zero rate (*R*=0), and a fixed release rate (*RR*) according to an example.
**FIG. 5B** shows the variations of the gain applied by an attenuation device over time for a dynamic attack rate (*AR*1 to *AR*5)*,* and a fixed release rate (*RR*) according to an example.
**FIG. 6** shows a flowchart of a method for computing a gain applied by an attenuation device according to an example.
**FIG. 7** shows a flowchart of a method for computing a clipping level according to an example.
**FIG. 8** shows a flowchart of a method implemented by a limiting device.
**FIG. 9** is an oscilloscope screenshot of a sine burst signal that illustrates the effect of a limiting device to the output signal and to the voltage of the bulk capacitor(s) of a multichannel amplifying device according to an example.
**FIG. 10** is a comparison of two audio signals, a small-signal version, and an amplified version with applied power limiting algorithm according to an example.
**FIG. 11** is an oscilloscope screenshot of a burst signal that illustrates the effect of a limiting device (including a clipping release rate) to the output and to the voltage of the bulk capacitor(s) of a multichannel amplifying device according to an example.

It should be noted that these figures are intended to illustrate the general characteristics of methods, structure and/or materials utilized in certain example embodiments and to supplement the written description provided below. The use of similar or identical reference numbers in the various drawings is intended to indicate the presence of a similar or identical element or feature.

### DETAILED DESCRIPTION

Various example embodiments will now be described more fully with reference to the accompanying drawings in which some example embodiments are shown. However, specific structural and/or functional details disclosed herein are merely representative for purposes of describing example embodiments. Accordingly, these embodiments are shown by way of illustrative examples in the drawings and will be described herein in detail so as to provide a thorough understanding of the various aspects. However, it will be understood by one of ordinary skill in the art that example embodiments are capable of various modifications and alternative forms and may be practiced without all the specific details. In addition, systems and processes may be shown in block diagrams so as not to obscure the example embodiments in unnecessary detail. In other instances, well-known processes, structures, and techniques may be shown without unnecessary detail in order to avoid obscuring the example embodiments.

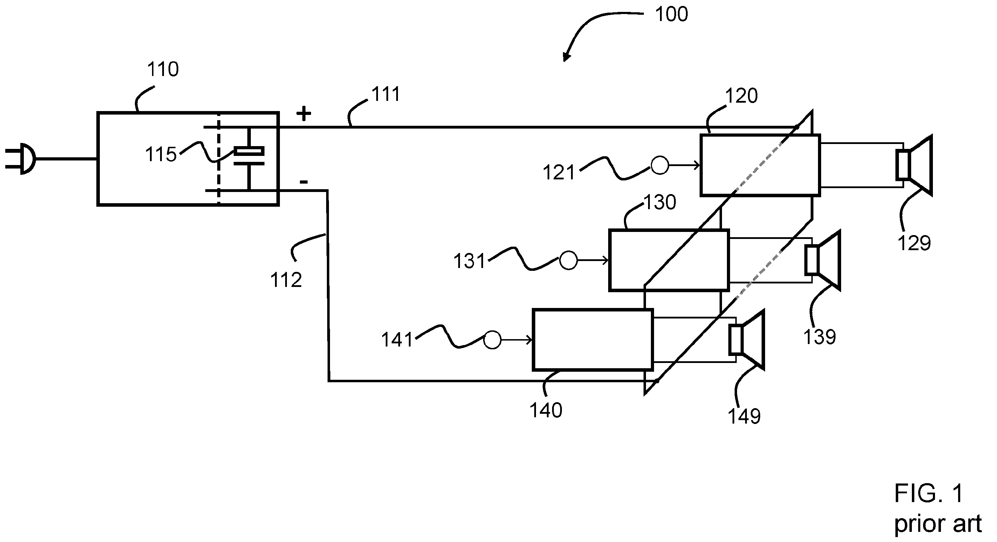

**FIG. 1** is a schematic block diagram of a multichannel amplifying system 100 with a power supply 110 that delivers power to several amplifier channels 120, 130, 140 with full bridge output stages driving bridge tied loads. Both expressions "amplifier channel" and "amplification channel" used herein relate to an audio channel and designate the functional block(s) configured for performing amplification of a corresponding input audio signal.

In the example audio system 100 shown in FIG. 1, a multichannel audio amplifier includes a power supply 110 that is connected to a power grid by a plug or a fixed connection. The power supply 110 delivers power to a group of amplifier channels 120, 130, 140.

The amplifier channels 120, 130, 140 are connected to the power supply, with at least a positive power connection 111 and a negative power connection 112. A bulk capacitor 115, at the output of the power supply, is connected between the positive power connection 111 and the negative power connection 112. Each amplifier channel 120, 130, 140 receives a respective input audio signal 121, 131, 141 and delivers a respective output audio signal to a respective load 129, 139, 149. Such a load is typically a loudspeaker.

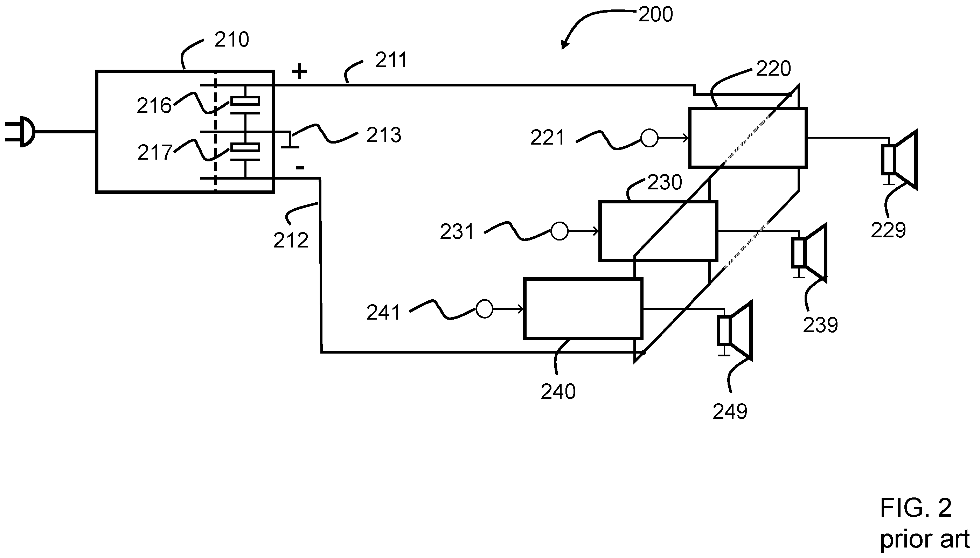

**FIG. 2** is a schematic block diagram of a multichannel amplifying system 200 with a power supply 210 having two symmetric supply voltages that delivers power to several amplifier channels 220, 230, 240 with half bridge output stages driving single ended loads.

The example audio system 200 shown in FIG. 2 includes, like in FIG. 1, a group of amplifier channels 220, 230, 240, but in this example the amplifier channels have a push-pull output configuration as illustrated by FIG. 2: there is a positive power connection 211, a negative power connection 212 and a third center connection 213 to a circuit ground potential. A first bulk capacitor 216 is connected between the positive power connection 211 and the center connection 213. A second bulk capacitor 217 is connected between the center power connection 213 and the negative power connection 212.

In a situation where several input audio signals and the amplifier channel gains cause the respective amplifier channels to output a higher-than-average power, the power supply may be overloaded: the maximum power delivered by the power supply 110 or 210 is less than the total power drawn by all amplifier channels together. In this case the bulk capacitors 115 or 216, 217 of the power supply will be discharged to deliver power from their stored energy, thereby lowering the supply voltage. Another reason for a decreasing supply voltage is, in case of a tightly regulated power supply, that the power supply falls out of regulation because the limitation of the maximum output current is reached. In this case the power supply is no longer a regulated voltage source but a current source with its maximum output current that is less than the load current. When a lower threshold of the supply voltage is reached, the power supply will switch off to prevent irregular operation or even damage. The interruption of the supply of power causes a muting of the output of the audio system.

Limiting devices operating under control of a common control device are introduced in order to limit the power drawn by the amplifier channels. Such a device is configured to limit the total sum of the power consumption of all channels to the maximum which the power supply can deliver. Typically, a short time overload of the power supply may be possible until the energy storage of the power supply is discharged to its minimum value.

The common control device is configured to implement a control function (also referred to herein as the control law) to determine an amount of power limitation to be applied. The control function may be based on one or more values of an indicator that may be computed dynamically. The indicator may represent an energy reserve stored in the bulk capacitor(s) supporting the output of the power supply. The physical parameter used for computing the value of the indicator may be a voltage or an energy. The lower the value of the indicator, the more power limitation is applied by the liming devices. The indicator may be proportional to the output voltage of the power supply or to the squared output voltage of the power supply. The indicator may be proportional to the stored energy in the power supply.

Each limiting device includes an attenuation device configured to apply an attenuation function and a clipping device configured to apply a clipping function.

The attenuation device may be implemented by any type of attenuator / amplifier suitable for applying a gain (less than one or equal to one, in linear domain, or, equivalently, less than 0 dB or equal to 0 dB in logarithmic domain) to an input signal in order to reduce the magnitude (e.g. voltage reduction in the analog domain, or numerical reduction in the digital domain) of the input signal. The attenuation device may be for example a voltage-controlled attenuator (VCA), a gain multiplier in a digital signal processing implementation, etc.

The clipping device may be implemented by any type of clipper suitable for reducing the magnitude (an amplitude in absolute value) of an input signal to a given clipping level.

A clipping device may include for example a series resistor with two clamping diodes connected to a positive threshold voltage and the second clamping diode to the inverted (negative) threshold voltage. An improved version may use an operational amplifier per clamping diode to compensate the diode forward voltage.

It may be also possible to emulate the clipping function of the clipping device using the attenuation device. If the magnitude of the input signal exceeds the threshold, the threshold is divided by this magnitude. The result is the gain to be applied (limited to an upper value of 0 dB) to obtain the clipped output signal.

For each audio channel, the output of the clipping device is connected to the input of the corresponding amplifier channel and the output of the attenuation device is connected to the input of the corresponding clipping device. Each attenuation device is configured to apply a gain to a corresponding input audio signal. The gain is applied by the attenuation device and this gain is e.g. negative or zero when expressed in dB, or the gain is above zero and below 1 or equal to 1 when expressed in linear domain. Each clipping device is configured to apply a clipping level to the signal generated by the attenuation device. The output signal of the clipping device is used in replacement of the input audio signal and is fed to the corresponding amplifier channel.

The indicator may be compared to a threshold to compute the gain to be applied to each audio channel in order to limit the total power drawn by the amplifier channels. The threshold is representative of a nominal energy level at which the power supply is in nominal operation. The threshold may be representative of a nominal voltage reflecting a nominal energy level.

The common control device is configured to generate control signals for the attenuation devices and clipping devices corresponding respectively to the gains and clipping levels determined by the control function on the basis of a current value of the indicator.

The gain decreases (more attenuation) when the value of the indicator is below the threshold and the gain increases (less attenuation) up to a maximum value when the value of the indicator is above the threshold. The gain may decrease over time by an attack rate. The attack rate may be a fixed attack rate that corresponds to a fixed gain decrease per time period in a logarithmic scale. The attack rate may be a dynamic attack rate computed as a function of the value of the indicator. The gain may increase over time by a release rate. The release rate may be a fixed release rate that corresponds to a fixed gain increase per time period in a logarithmic scale. The gain may vary between a minimum value (e.g. a fixed minimum value) and a maximum value (e.g. a fixed maximum value).

The clipping level is determined as a monotonic function of the value of the indicator. For example, the clipping level decreases (more clipping) when the value of the indicator decreases (lower energy reserve) and vice versa. For example, when the value of the indicator is below the threshold, the clipping level is determined by applying a monotonic function of an output voltage of the power supply. The monotonic function may be a linear function of the output voltage of the power supply or have another shape. The monotonic function may be determined based on mains voltage level signal received from the power supply.

The clipping level may be determined by applying a linear function to a voltage at the output of the power supply when the indicator is proportional to the voltage at the output of the power supply. The clipping function may have no effect (clipping level higher than a maximum value) as long as the value(s) of the indicator are above the threshold representative of a nominal energy level.

The values of the clipping level and / or the gain may be dynamically adjusted by the common control device. The clipping level and / or the gain may be dynamically adjusted as a function of value(s) of the indicator.

In case of a temporary too high total power consumption of all amplifier channels, the energy reserve may decrease so quickly that gain reduction alone may not be sufficient. An attenuation device that applies a gain with an attack rate may not prevent the power supply from switch-off before a sufficient gain reduction is reached. Thus, it is necessary to have an instantaneous acting mechanism. To act instantaneously, a clipping device is used in combination with the attenuation device and configured in order to apply a clipping level at the beginning of a power peak, giving enough time for the attenuation device to take over, i.e. to reach a sufficiently decreased gain so that the value of the indicator does not drop any further.

However, a disadvantage of heavy clipping are audible artifacts for longer time durations. Here the attenuation performed by the attenuation device with its attack ramp allows to limit the signal such that, e.g. after a first period of time (attack phase), for example 250 ms, to a level where no clipping occurs anymore. This means that during a second time period (release phase) after the first period of time, no clipping occurs (the clipping function has no effect on the signal received by the clipping device), and the limitation of the audio signal results from the gain applied by the attenuation function, while still being in the attack phase in which the energy reserve has not reached the nominal energy level. After an event with high peak power in several channels at the same time, the instantaneously working clipping device may return to a clipping level above the maximum signal amplitude. During a third time period, once the energy reserve has reached the nominal energy level, the gain increases (e.g. at a slow rate to avoid pumping effects in the audio signal) up to a maximum gain level (e.g., 0 dB).

The attack phase may start after the occurrence of a power consumption peak which results in a discharge of energy of bulk capacitor(s), this discharge being detected based on one or more values of the indicator. A release phase may be interrupted by a second attack phase if a new power consumption peak occurs. Release phases and attack phases may alternate in time as a function of the variations of the values of the indicator.

A combination of clipping and dynamic attenuation can preserve a high average power level and hence loudness, with an output signal that has sufficiently low audible artifacts. The combination can react fast enough to protect the power supply from a switch-off condition during high-power output.

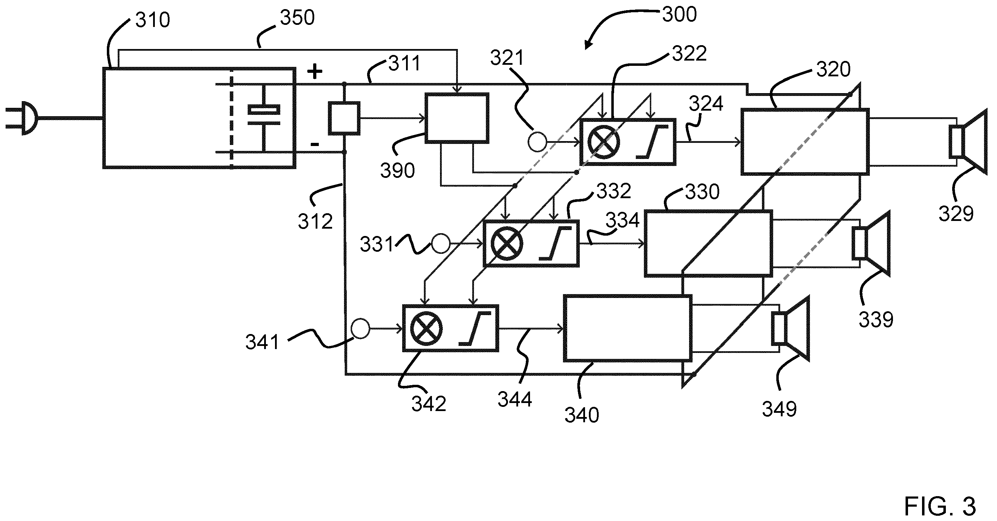

FIG. 3 is a schematic block diagram of a multichannel amplifying system 300. The multichannel amplifying system 300 include a limiting device 322, 332, 342 before each amplifier channel 320, 330, 340, each limiting device 322, 332, 342 being controlled by a common control device 390 that is common to all amplifier channels and uses information of state of the supply voltage. In the example of FIG. 3, as in FIG. 1, the full bridge output stages are driving bridge tied loads.

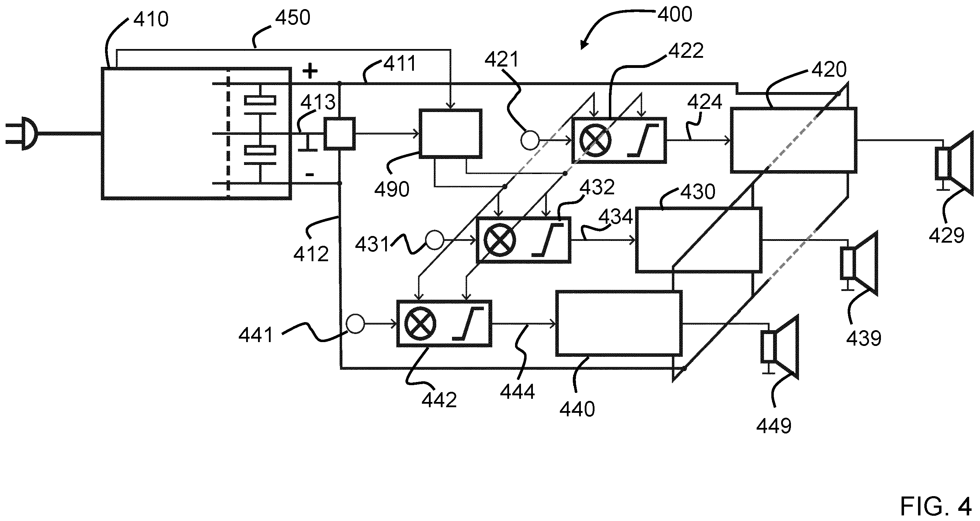

FIG. 4 is a schematic block diagram of a multichannel amplifying device 400. The multichannel amplifying system 400 include a limiting device 422, 432, 442 before each amplifier channel 420, 430, 440, each limiting device 422, 432, 442 being controlled by a common control device 490 that is common to all amplifier channels and uses information of the supply voltage. In the example of FIG. 4, as in FIG. 2, the half bridge output stages are driving single ended loads.

For simplicity in FIG. 3, the diagram is drawn with a power supply 310 that has only one supply voltage (between 311 and 312), supplying power to a group of amplifier channels 320, 330, 340 that are using bridge tied loads 329, 339, 349, requiring only one power supply voltage.

It is also possible to have single-ended push-pull output stages at the amplifiers which need a positive and a negative supply voltage like the system 400 of FIG. 4. Here the power supply 410 has a positive supply voltage (between 411 and 413) and a negative supply voltage (between 412 and 413) that share a common ground at a center connection 413 in between. In this case, the state of the power supply is given by the minimum of the absolute values of both the positive and the negative power supply voltages.

In each audio channel of FIG. 3 or 4, the limiting device 322, 332, 342, 422, 432, 442 receives a respective input audio signal 321, 331, 341, 421, 431, 441 of the concerned audio channel and delivers a respective limited audio signal 324, 334, 344, 424, 434, 444 replacing the respective input audio signal 321, 331, 341, 421, 431, 441 to the respective amplifier channel 320, 330, 340, 420, 430, 440.

Each limiting device 322, 332, 342, 422, 432, 442 comprises an attenuation device followed by a clipping device.

Each attenuation device receives from a common control device 390, 490 an input control signal configured to control the value of the gain applied by the concerned attenuation device. The control signal may be identical for all audio channels. If the gain is set to the maximum of 0 dB (i.e., corresponding to a multiplication factor of one), the input audio signal remains unchanged.

Each clipping device receives from a common control device 390, 490 an input control signal configured to control the values of positive and negative clipping levels applied by the concerned clipping device. For each clipping device, the maximum positive and negative saturation thresholds (i.e. the maximum positive and negative values of the clipping level) are set to the maximum signal level that can be handled by the respective amplifier stage at its input. Usually, this maximum signal level is limited by the supply voltage, which is divided by the amplifier voltage gain of the amplifier channel.

The common control device 390, 490 may use different information available to generate the input control signals.

In the embodiment of FIG. 3, a supply voltage (between 311 and 312) at the bulk capacitor(s) of the power supply is used and transmitted to the common control device 390. With two symmetric power supply voltages and a push-pull configuration as in FIG. 4, the two supply voltages (between 411 and 413, and between 412 and 413) are used and the minimum of the absolute values of these two voltages is transmitted to the common control device 490.

Several types of control signals may be generated by the common control device to control the gains and clipping levels.

The gain may be adjusted by applying an attack rate (e.g. a linear decrease as a function of time when the gain is expressed in dB) during an attack phase, and/or by applying a release rate (e.g. a linear increase as a function of time when the gain is expressed in dB) during a release phase. The gain control signal is identical for all audio channels. The gain may vary between a maximum value (e.g. equal to 0 dB, i.e. no attenuation) and a minimum value. The attack rate and / or release rate may be fixed or determined based on a difference between an indicator and a threshold representative of a nominal energy level. The release rate may be smaller in absolute value than the attack rate such that the release phase lasts longer than the attack phase. A trade-off may be found between reacting too fast (causing low average power) or too slow (causing a too long time of gain reduction period with additional clipping of the input audio signal). As long as the energy reserve represented by the indicator is above the threshold, the gain is in a release phase, and it is limited to the maximum gain (e.g. equal to 0 dB, i.e. no attenuation).

The gain may decrease (i.e. more attenuation) as a function of time during a first time period (attack phase) and may increase (i.e. less attenuation) as a function of time during a second time period (release phase). For example, during the attack phase, the gain decreases with a constant attack rate (e.g. a predefined attack rate) or with a dynamic attack rate. The attack rate(s) and release rate(s) represent a variation over time (increase or respectively decrease) of the gain. The dynamic attack rate may be adjusted as a function of the difference between the threshold and the current value of the indicator.

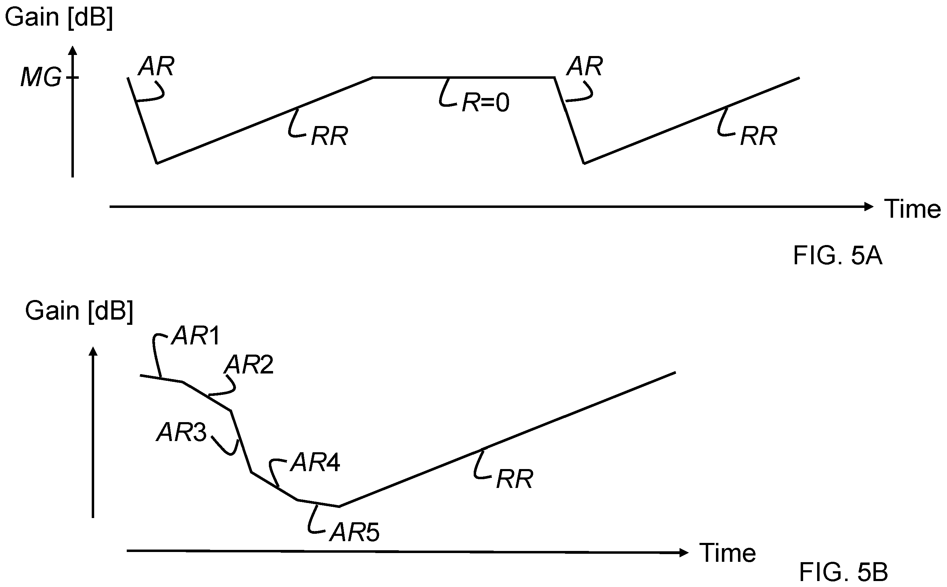

For example, as represented by FIG. 5A, the attack rate (*AR*) and the release rate (*RR)* are fixed, and the attack phases alternate with release phases. During the release phase, the gain is limited to the maximum gain value (*MG,* e.g. 0 dB). This limiting may cause a part of the release phase to have a zero rate of gain change (R=0), while the gain remains at its maximum gain value (*MG*)*.*

For example, as represented by FIG. 5B, the dynamic attack rate is adjusted according to the difference between the indicator value and the threshold. When the energy reserve represented by the indicator decreases, the difference increases, and the dynamic attack rate also increases and vice versa.

FIG. 5B shows a curve illustrating the variations of the gain, with a first slope corresponding to the first attack rate *AR*1 (linear decreases of the gain when expressed in dB) during a first period of time, a second attack rate *AR*2 during a second period of time. Likewise other attack rates *AR*3*, AR*4*, AR*5 may be used during subsequent corresponding periods of time. In this example, the dynamic attack rate is updated at the transitions from *AR*1 to *AR*2*,* from *AR*2 to *AR*3*,* and so on. Update of the dynamic attack rate may occur with the control update rate at which the values of the indicator are evaluated by the common control function.

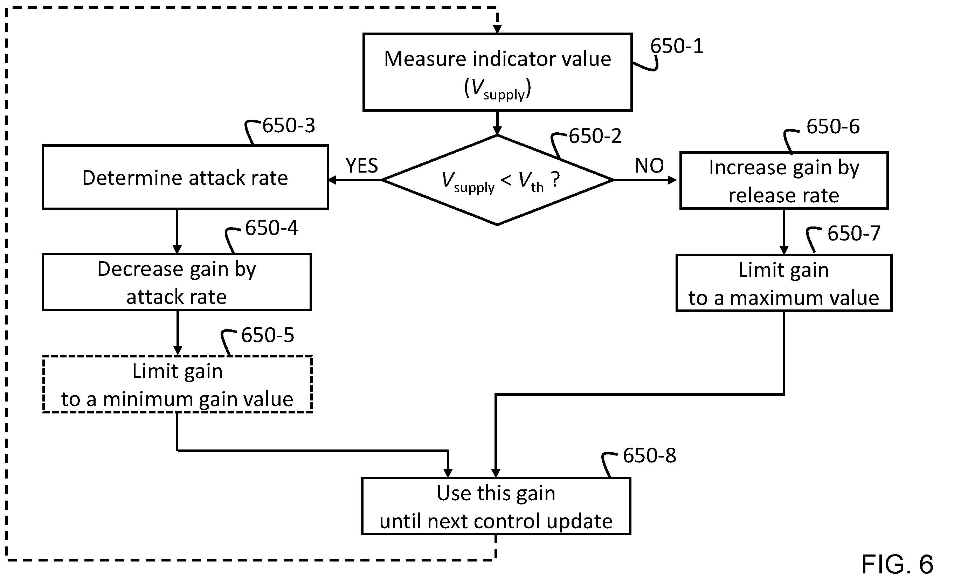

FIG. 6 shows a flowchart of a method for determining a gain of an attenuation function according to an example. In step 650-1, a value of the indicator is obtained. The indicator may be the measured supply voltage at the bulk capacitor(s), in this example the supply voltage *V*_{supply}. In step 650-2, the indicator value is compared to the threshold *V*ₜₕ, here the voltage level of nominal operation.

If the value of the indicator is below the threshold, step 650-3 is executed after step 650-2. Otherwise, if the value of the indicator is above or equal to the threshold step 650-6 is executed after step 650-2.

If the indicator is below the threshold, the method continues with step 650-3, the attack rate is determined. This can be a fixed attack rate as in FIG. 5A. This can also be a dynamic attack rate as in FIG. 5B. For a dynamic attack rate, a weighting factor *w* may be calculated as a ratio of two differences, here *w* = (*V*ₜₕ - *V*_{supply}) / (*V*ₜₕ - *V*ₘᵢₙ). In this example, the nominal voltage is *V*ₜₕ = 155 V, and the minimal voltage of safe operation is *V*ₘᵢₙ = 130 V. Thus, the weighting factor *w* is a number between 0 and 1. With a (logarithmic) maximum attack rate of -0,2085 dB/ms and a gain update rate of 24 kHz, the maximum attack rate is corresponding to a factor *FA*ₘₐₓ = 0,999 in a linear scale. Using the current value of *w,* a dynamic attack rate is calculated, corresponding to a factor *FA*_{d} *=* 1 *- w*·(1 *- FA*ₘₐₓ).

In step 650-4, the gain is decreased by this factor, such that the updated value of the gain is gain·*FA*_{d}. As an optional step 650-5, the gain may be limited to a minimum gain value, e.g. to a value of 0,01. A minimum gain value can help to shorten the duration of a subsequent release phase. As shown in step 650-8, this gain is then used for all attenuation devices until the next control update, e.g. a next execution of step 650-1 where a new value of the indicator is obtained. The control update rate at which the values of the indicator are evaluated may be slower than the gain update rate at which the values of the gain are updated.

If the indicator is above or equal to the threshold, the method continues with step 650-6. The gain is increased by a release rate, e.g. a fixed release rate of 20,85 dB/s and a gain update rate of 24 kHz, corresponding to a factor *FR =* 1,0001 in a linear scale. The gain is increased by this factor: gain = gain·*FR*. Instep in step 650-7, the gain is limited to a maximum gain value, e.g. to a value of 1 in linear scale. As shown in step 650-8, this gain is then used for all attenuation devices until the next control update.

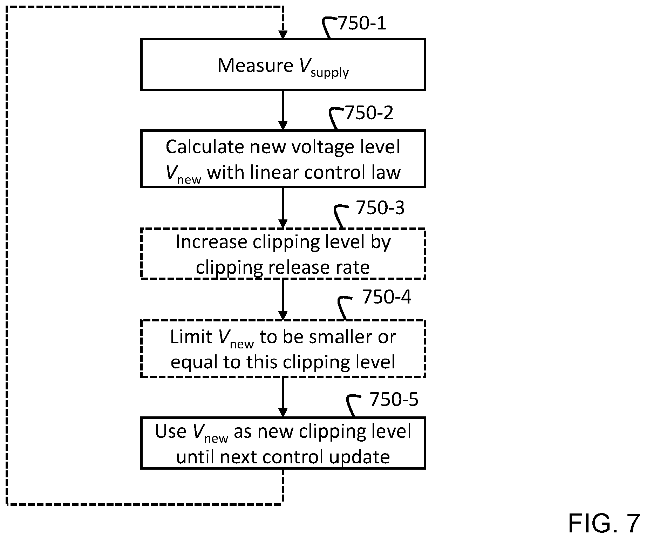

FIG. 7 shows a flowchart of a method for computing a clipping level of a clipping function using a control function according to an example. In step 750-1, the calculation is based on the measured supply voltage at the bulk capacitor(s). In step 750-2, a new voltage level is calculated as a function of *V*_{supply} with a linear control law, *V*_{new} *= c*·*V*_{supply} + *V*_{offset}. The coefficient *c* and the voltage *V*_{offset} may be pre-calculated depending on mains voltage RMS level at the input of the power supply and on the load impedance connected at the output of a given amplifier channel.

For example, to determine the coefficients of the linear control law, two operating points are used. A first operating point is when the supply voltage is at nominal level (*V*_{supply} = *V*ₜₕ), the linear control law returns *V*_{new} = *V*ₜₕ + *V*ᵣᵢₚₚₗₑ, where the power supply has a nominal voltage of *V*ₜₕ = 155 V, varying for example from 150 V to 160 V with *V*ᵣᵢₚₚₗₑ = 5 V. A second operating point is when the supply voltage is at minimal level (*V*_{supply} = *V*ₘᵢₙ), the linear control law returns a voltage level *V*_{new} such that the connected load impedance can be operated with any signal at that voltage level without exceeding the long-term maximum average power level per channel. These two conditions for *V*_{new} allow to precalculate both *c* and *V*_{offset} for each amplifier channel and its respective load impedance.

As two optional steps 750-3 and 750-4, the current clipping level is increased by a fixed clipping release rate (in dB/s) *CRR* in step 750-3, e.g. *CRR =* 16 dB/s. For a discrete-time implementation, the numerical value of a clipping level release factor may be chosen according to the control update rate. In step 750-4, the new voltage level *V*_{new} is limited to be smaller or equal to the clipping level. This way, fluctuations of the supply voltage *V*_{supply} have less influence on the clipping level. However, if *CRR* is chosen too slow, clipping may last for unnecessary long time periods until attenuation by gain reduction can take over. Steps 750-3 and 750-4 may both be used, or both be omitted.

As shown in step 750-5, the new voltage level *V*_{new} is then used as the clipping level for all clipping devices until the next control update, e.g. when a new value of the supply voltage at the bulk capacitor(s) is evaluated by the common control function.

The clipping level may be determined by the common control device based on the indicator. The clipping level may be determined for each audio channel in dependence of the connected load impedance of the considered amplifier channel and the supply voltage, which is the voltage at the output of the power supply.

As long as the indicator is above the threshold, the gain is limited in release phases to a maximum value (e.g. 0 dB, no attenuation), and likewise the clipping level is set to a level (and may be limited to a maximum level) at which the clipping is inactive.

Concerning the determination of the indicator, several algorithms may be used separately or in combination.

According to an algorithm, the value of the indicator is obtained by sampling the voltage at the output of the power supply. A good marker of the available energy reserve is the power supply output voltage (between 311 and 312 in FIG. 3 ; or between 411 and 413, and between 412 and 413 in FIG. 4 ; in FIG. 4, the minimum of the absolute value of the positive and the negative supply voltage is taken). The available energy reserve may thus be computed as *E* = 0,5·*C*_{B}·(*V*_{supply})², where *C*_{B} is the effective capacitance of the bulk capacitor(s) and *V*_{supply} is the voltage at the output of the power supply. The control function is configured to calculate a gain and a clipping level to be applied to some or all of the audio channels on the basis of the available energy reserve.

The common control device may receive as input the value of the indicator representing the bulk capacitor(s) voltage, and calculates a gain and a clipping level to be applied to some or all of the audio channels.

Example embodiments of control functions and the adjustment of the thresholds and parameters are provided below.

The control function may compare the measured supply voltage with a threshold set to 155 V. If the measured supply voltage is higher than 155 V, a gain release phase is applied.

If the measured supply voltage is below 155 V, then more attenuation is applied to the gain over time (with the gain update rate) by a certain amount. Typical attack rates for dynamic compressors of music signals are in the range of 0,04 dB/ms up to 3 dB/ms. In an embodiment suitable for music signals, the attack rate of the gain is dynamically calculated and not set to a fixed value. A linear control equation may be used. Hereby the largest attack rate is reached at 130 V, which is 25 V below the threshold of 155 V. For instance, this attack rate may be set to 0,25 dB/ms. If the measured voltage is only 5 V below the threshold (measured supply voltage is 150 V) then the attack rate is set to 0,05 dB/ms. Using analog hardware circuitry, the control function may be implemented with some comparators, differential amplifiers and an integrator to match the demand of the attenuation device (e.g. a voltage-controlled attenuator, VCA). The control function may can be implemented in a programmable device like a microcontroller with memory, an FPGA or CPLD or a DSP, etc. In this case the power supply voltage may be provided by an analog to digital converter.

If the measured voltage is larger than the 155 V nominal operation voltage, then less attenuation should be applied, returning from its present value back to 0 dB (no attenuation) by a fixed release rate in the range of 5 dB/s up to 250 dB/s, with a preferable release rate of 25 dB/s.

In one or more embodiments this calculated attenuation is applied to all channels of the multichannel amplifier. But in other embodiments, it might be of interest with a-priori knowledge to exclude some audio channels from attenuation, because it is known that they do not consume much power. So, if the audio system drives active crossover loudspeaker systems it might make sense only to attenuate the subwoofer and bass channels and keep the loudness of mid and high frequency channels (drawing only little power by design) of the system. In other embodiments, one might choose the channels with the highest instantaneous output power to attenuate them first.

While the described control scheme allows for a good and musically sounding power supply, supply voltage dependent attenuation of the music signals in different audio channels might not prevent a switch-off condition in any case. The reason is that good sound quality is only achieved with moderate attack rates of typically 0,25 dB/ms. To secure the system, an additional instantaneous acting mechanism is necessary.

Here the clipping level (corresponding to a clipping voltage) calculation is used for. There may be a linear control function between the power supply voltage and the clipping level corresponding to a maximum output signal voltage that can be reached until the clipping device will clip its input signal accordingly. For this control function other control functions than a linear control function are possible, but they should be monotonic increasing as a function of the value of V_{supply}.

As a numerical example, an audio system with *N*_{ch} = 8 channels and a common power supply delivering *P*_{supply} = 2500 W is used. The power supply has a nominal voltage of *V*ₜₕ = 155 V, varying from 150 V to 160 V with *V*ᵣᵢₚₚₗₑ = 5 V, and an idle voltage *V*_{idle} = 177 V. If no power is drawn from the power supply, the supply voltage *V*_{supply} goes up to *V*_{idle} . The power supply is assumed to deliver a constant power value *P*_{supply} for all supply voltages below *V*_{supply} = *V*ₜₕ + *V*ᵣᵢₚₚₗₑ . Assuming that losses in the amplifier stages can be ignored, each channel has a steady state output power budget of *P*_{ch} = *P*_{supply} / *N*_{ch} = 312,5 W. For safe operation of the amplifier, the supply voltage may not drop below *V*ₘᵢₙ = 130 V. A load impedance of *R*_{load} = 8 Ω is assumed for all audio channels.

A margin (or voltage difference) of at least *V*_{diff} = 5 V must always remain between the supply voltage and the maximum signal voltage at the amplifier output. To set up a linear control law for the clipping level voltage, two operating points may be defined. First, at nominal supply voltage *V*ₜₕ, the signal voltage corresponding to a high clipping level is *V*_{high} = *V*ₜₕ - *V*_{diff} = 150 V. Second, at lowest supply voltage *V*ₘᵢₙ, the power dissipation per channel must not exceed *P*_{ch} even for a square wave (rectangular) output signal shape. Thus the voltage corresponding to a low clipping level is *V*_{low} computed as the square root of the product *P*_{ch}. *R*_{load}, where is *R*_{load}, the total load impedance of the channel, giving *V*_{low} = sqrt(*P*_{ch}·*R*_{load}) = 50 V. With these two operating points, a linear control function can be defined to calculate a clipping level depending on the supply voltage, *V*_{clip} = *c*·*V*_{supply} - *V*_{offset} where *V*_{supply} is the current value of the supply voltage used as indicator. The coefficient for this linear control function is *c* = (*V*_{high} - *V*_{low}) / (*V*ₜₕ - *V*ₘᵢₙ) = 4. The offset for this linear control function is *V*_{offset} = *c*·*V*ₜₕ - *V*_{high} = 470 V.

Thus, at 130 V supply voltage (the switch-off threshold), the clipping device only allows for 50 V maximum voltage at the amplifier channel output. With an 8 Ω load and a signal with clipped rectangular shape, the power per channel is (50 V)² / (8 Ω) = 312,5 W. Multiplied by the number of channels gives the total power the supply must deliver at 130 V supply voltage. This way, an audio system with 8 channels is protected if the power supply can deliver 2500 W at 130 V supply voltage. The power has to be a little bit higher because of the efficiency of the amplifier channels. A skilled person designing such an amplification system is easily able to adapt these example values to the needs of a specific audio system.

At a supply voltage of 155 V, the clipping level is calculated by the linear equation to 150 V output clipping voltage. This is a reasonable margin to be considered between the supply voltage and the output voltage that a typical amplifier can reach. When the clipping level is above the maximum output level, the clipping device has no effect, i.e. it does not change the output signal.

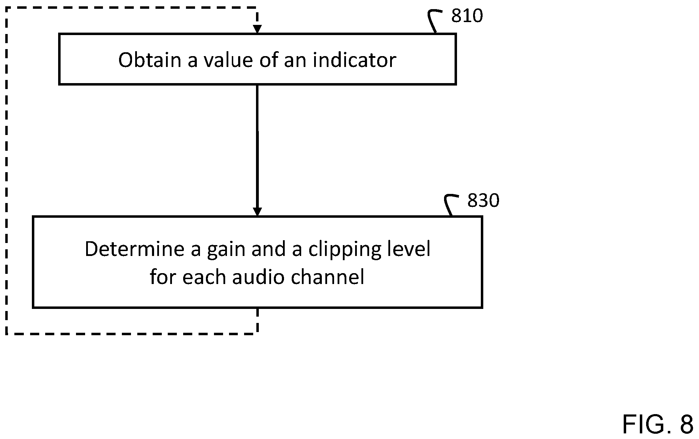

FIG. 8 shows a flowchart of a method implemented by a limiting device according to an example. The method is for use in an audio system including a plurality of amplifier channels of corresponding audio channels. Each of the amplifier channels receives a respective input audio signal and being powered by a same power supply.

In step 810, a value of an indicator is obtained. The indicator is representative of an energy reserve of the power supply.

In step 830, for each of the amplifier channels, a gain to be applied by an attenuation function to the respective input audio signal and a clipping level to be applied by a clipping function to the output of the attenuation function are determined. The gain decreases when the value of the indicator is below a threshold and the gain increases up to a maximum value when the value of the indicator is above the threshold. The threshold is representative of a nominal energy level at which the power supply is in nominal operation. The clipping level is determined as a monotonic function of the value the indicator.

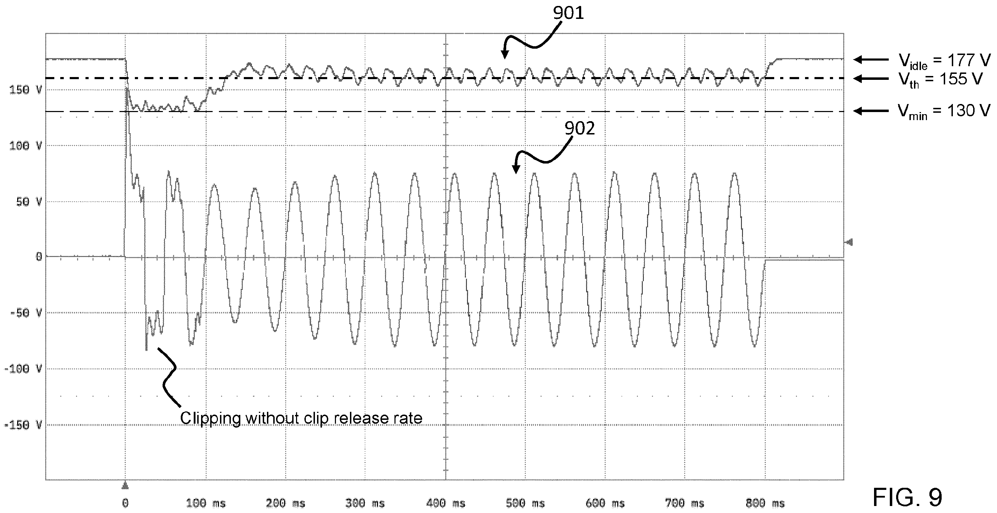

To demonstrate the operation, FIG. 9 shows the dropping supply voltage 901 as system reaction to a burst signal at all audio inputs. FIG. 9 is an oscilloscope screenshot of a sine burst signal 902 that illustrates the effect of the limiting device to the output signal and to the voltage of the bulk capacitor(s) of a multichannel amplifying device.

At the beginning, the output signal 902 is clipped by the clipping device because of the low supply voltage values after the sudden voltage drop as reaction to the high power demand. After 100 ms the gain reduction takes over, meaning that no more signal clipping occurs after this time instant. Now the output signal is sinusoidal again. The reduced amplitude (and hence reduced output power) led to a recovery of the supply voltage. When the supply voltage reaches *V*_{supply} = *V*ₜₕ, the control function releases the gain and the sinusoidal output voltage rises a little bit. In the steady state region, time intervals of attack and release may alternate so that the attenuation level is nearly constant. (If the indicator remains above threshold, meaning *V*_{supply} > *V*ₜₕ , the gain may remain in a release phase, while it is limited to its maximum value.) Frequently the supply voltage falls below the threshold of 155 V. Hence the gain is reduced again by an attack rate of 0,01 dB/ms at 154 V, then 0,05 dB/ms at 150 V, reaching 0,25 dB/ms at 130 V supply voltage.

If the load impedance is for instance 4 Ω instead of 8 Ω, a different control law has to be evaluated. The power of 312,5 W is reached with 4 Ω at a clipping voltage of 35,36 V. This must be reached at 130 V supply voltage.

In an audio system with different load impedances, 2 or more clipping levels may be calculated, one for each load impedance Also for each different load impedance, a respective control signal from the common control device to the clipping device in the amplifier channel is generated. While the gain may be identical for all channels, the clipping level may depend on the attached load, which may be different (e.g., 4 ohms or 8 ohms) for different channels.

Depending on the properties of the power supply, the maximum power rating of the supply may depend on the available mains voltage. Throughout the world there are 100 V, 120 V, and 230 V operating ranges in use. The clipping level calculation may be adapted to these ranges. To realize this, the information of the mains voltage is passed over to the clipping level calculation device with the signal 350, 450. So in a special embodiment there might be 3 sets of control equations for 100 V, 120 V and 230 V for the different loads of 4 Ω and 8 Ω. The clipping level calculation equation is chosen according to the actual operation condition. Even a continuous adaption of the clipping level calculation equation is possible according to the mains voltage. A skilled person in art may adapt this clipping level calculation to the needs of the power supply used in their multichannel amplification system.

In the example of FIG. 9, a burst signal starts at time 0 ms. The signal's output voltage exceeds 150 V. The result of that load is a sudden drop of the power supply voltage from its idle voltage V_{idle} = 177 V down to supply voltages slightly above *V*ₘᵢₙ = 130 V. The threshold is set to Vₜₕ = 155 V. The common control device maps the supply voltage to a time-varying clipping level. In the time interval from 0 ms to 100 ms, the output signal is clipped and has no sinusoidal shape. In addition, the gain applied by the attenuation device is reduced with an attack rate of nearly 0,25 dB/ms. Thus, a gain reduction of almost 25 dB is reached after 100 ms. At this time, the amplitude of the burst signal is so far attenuated that the signal peaks are below the clipping level. Because the signals of all channels are reduced, the supply voltage rises back to a steady state, slightly fluctuating around nominal voltage. The calculation device reacts to the higher-than-threshold voltage by increasing the gain with a release rate of 25 dB/s. So the output signal amplitude rises a little bit. That results in a slightly lower power supply voltage. From 300 ms on, the gain applied by the attenuation device is nearly constant because release phases are interrupted by attack phases such that the supply voltage is fluctuating (in the range of the ripple voltage) around nominal voltage (that is related to the threshold level).

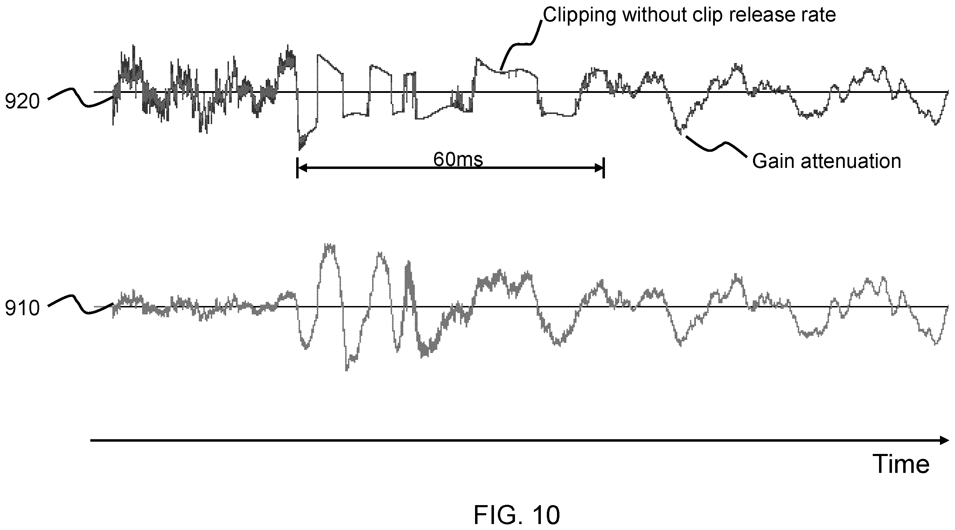

FIG. 10 is a comparison of two music signals. Bottom diagram is the original signal 910 played back at a low level. At the top is the same signal 920 played back at a much higher level overloading the power supply so that the common control device calculates the clipping level to cut the high output amplitudes and calculates a gain to attenuate the music signal in all channels.

Here the original signal 910 is at a sufficiently low level where there is no drop of the supply voltage into the range where the clipping and attenuation devices are acting. When the input signal is provided with much larger gain to the multichannel amplification system, the supply voltage drops suddenly when the amplitude of the music signal changes to large amplitudes. Then the clipping level is reduced instantaneously. This results in a first time period (attack phase) with 60 ms duration showing heavy clipping of signal peaks. During that time the gain applied by the attenuation device is further reduced. At the end of that first time period the signal is sufficiently attenuated to show the same amplitude shape as the original signal shown below.

It can be observed in FIG. 9 and in FIG. 10 that the power supply voltage has some signal and mains frequency dependent ripples that are "modulating" the calculated clipping level for the audio signal. In another embodiment it is possible to store the minimum of the previously calculated clipping levels and apply a clipping release rate of e.g., 16 dB/s to it. If there is a new minimum of the clipping level, then it overwrites the stored clipping level. This can be realized as an approximation with a capacitor charged by a current source and a diode that can directly discharge or clamp the capacitor voltage to the calculated clipping voltage calculated from the power supply voltage. The capacitor voltage is then used to set the clipping voltage in each amplification channel. This of course can also be realized in software when the signal chain is realized digitally, and the amplifier has a digital input and using a digital to analog converter or a digital PWM modulator that receives a digital input signal.

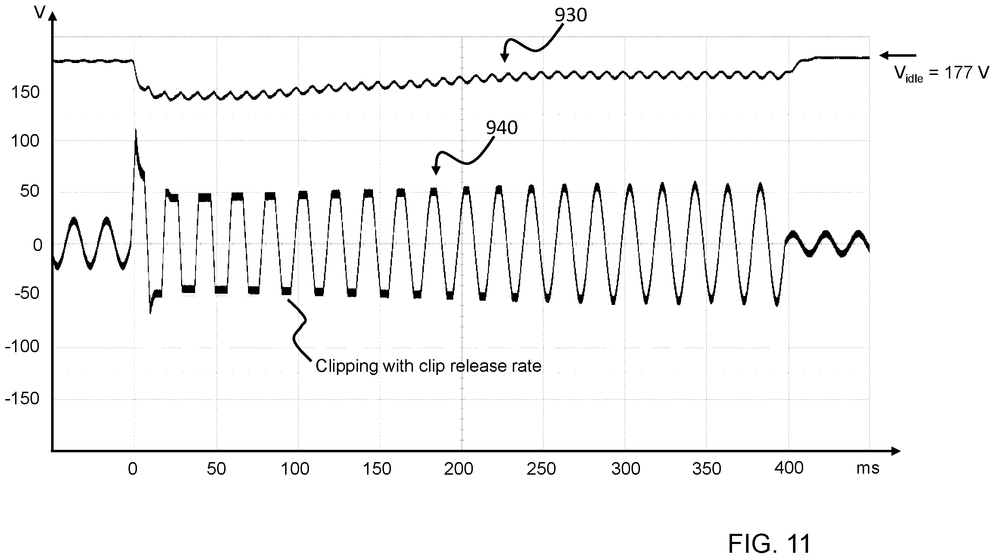

FIG. 11 is an oscilloscope screen shot of a burst signal that illustrates the effect to the output signal 940 of a multichannel amplifying device, using a fixed release rate for the calculated clipping level in combination with a minimum operation to the clipping level derived from the instantaneous power supply voltage 930.

During the time period when the output signal 940 is clipped there are "flat tops" from this clipping action. No modulation from supply voltage ripples can be seen. The disadvantage of that embodiment is that there might be longer time intervals where the signal is clipped. The reason is that the level of clipping is rising faster by the instantaneous calculation of the clipping level according to the supply voltage.

It should be appreciated by those skilled in the art that any functions, engines, block diagrams, flow diagrams, state transition diagrams, flowchart and / or data structures described herein represent conceptual views of illustrative circuitry embodying the principles of the invention. Similarly, it will be appreciated that any flowcharts, flow diagrams, state transition diagrams, pseudo code, and the like represent various processes which may be substantially represented in computer readable medium and so executed by a computer or processing apparatus, whether or not such computer or processor is explicitly shown.

Although a flowchart may describe operations as a sequential process, many of the operations may be performed in parallel, concurrently or simultaneously. Also, some operations may be omitted, combined or performed in different order. A process may be terminated when its operations are completed but may also have additional steps not disclosed in the figure or description. A process may correspond to a method, function, procedure, subroutine, subprogram, etc. When a process corresponds to a function, its termination may correspond to a return of the function to the calling function or the main function.

Each described function, engine, block, step described herein can be implemented in hardware, software, firmware, middleware, microcode, or any suitable combination thereof.

When implemented in software, firmware, middleware or microcode, instructions to perform the necessary tasks may be stored in a computer readable medium that may be or not included in a host apparatus or host system. The instructions may be transmitted over the computer-readable medium and be loaded onto the host apparatus or host system. The instructions are configured to cause the host apparatus or host system to perform one or more functions disclosed herein. For example, as mentioned above, according to one or more examples, at least one memory may include or store instructions, the at least one memory and the instructions may be configured to, with at least one processor, cause the host apparatus or host system to perform the one or more functions. Additionally, the processor, memory and instructions, serve as means for providing or causing performance by the host apparatus or host system of one or more functions disclosed herein.

The host apparatus or host system may be a general-purpose computer and / or computing system, a special purpose computer and / or computing system, a programmable processing apparatus, an audio system, a machine, etc.

The instructions may correspond to computer program instructions, computer program code and may include one or more code segments. A code segment may represent a procedure, function, subprogram, program, routine, subroutine, module, software package, class, or any combination of instructions, data structures or program statements. A code segment may be coupled to another code segment or a hardware circuit by passing and/or receiving information, data, arguments, parameters or memory contents. Information, arguments, parameters, data, etc. may be passed, forwarded, or transmitted via any suitable technique including memory sharing, message passing, token passing, network transmission, etc.

When provided by a processor, the functions may be provided by a single dedicated processor, by a single shared processor, or by a plurality of individual processors, some of which may be shared. The term "processor" should not be construed to refer exclusively to hardware capable of executing software and may implicitly include one or more processing circuits, whether programmable or not. A processor or likewise a processing circuit may correspond to a digital signal processor (DSP), a network processor, an application specific integrated circuit (ASIC), a field programmable gate array (FPGA), a System-on-Chips (SoC), a Central Processing Unit (CPU), a quantum processor, an arithmetic logic unit (ALU), a programmable logic unit (PLU), a processing core, a programmable logic, a microprocessor, a controller, a microcontroller, a microcomputer, any device capable of responding to and/or executing instructions in a defined manner and/or according to a defined logic. Other hardware, conventional or custom, may also be included. A processor or processing circuit may be configured to execute instructions adapted for causing the host apparatus or host system to perform one or more functions disclosed herein for the host apparatus or host system.

A computer readable medium or computer readable storage medium may be any storage medium suitable for storing instructions readable by a computer or a processor. A computer readable medium may be more generally any storage medium capable of storing and/or containing and/or carrying instructions and/or data. A computer-readable medium may be a portable or fixed storage medium. A computer readable medium may include one or more storage device like a permanent mass storage device, magnetic storage medium, optical storage medium, digital storage disc (CD-ROM, DVD, Blue Ray, etc.), USB key or dongle or peripheral, a permanent mass storage device such as a disk drive, a hard disk drive (HDD), a solid state drive (SSD), a memory card, a read only memory (ROM), core memory, flash memory, or any other non-volatile storage, or any combination thereof.

In the present description, the wording "means configured to perform one or more functions" or "means for performing one or more functions" may correspond to one or more functional blocks comprising circuitry that is adapted for performing or configured to perform the concerned function(s). The block may perform itself this function or may cooperate and / or communicate with other one or more blocks to perform this function. The "means" may correspond to or be implemented as "one or more modules", "one or more devices", "one or more units", etc. The means may include circuitry configured to perform the concerned function(s). The means may include at least one processor and at least one memory including computer program code, wherein the at least one memory and the computer program code are configured to, with the at least one processor, cause an apparatus or system to perform the concerned function(s).

As used in this application, the term "circuit" or "circuitry" may refer to hardware-only circuit implementations, combinations of hardware circuits and software, hardware circuit(s) that requires software (e.g., firmware) for operation, a processor. The term "circuit" or "circuitry" may for example cover digital signal processor (DSP) hardware, network processor, application specific integrated circuit (ASIC), field programmable gate array (FPGA), etc. The circuitry may be or include, for example, hardware, programmable logic, a programmable processor that executes software or firmware, and/or any combination thereof (e.g. a processor, control unit/entity, controller) to execute instructions or software and control transmission and receptions of signals, and a memory to store data and/or instructions.

Although the terms first, second, etc. may be used herein to describe various elements, these elements should not be limited by these terms. These terms are only used to distinguish one element from another. For example, a first element could be termed a second element, and similarly, a second element could be termed a first element, without departing from the scope of this disclosure. As used herein, the term "and/or," includes any and all combinations of one or more of the associated listed items.

The terminology used herein is for the purpose of describing particular embodiments only and is not intended to be limiting. As used herein, the singular forms "a," "an," and "the," are intended to include the plural forms as well, unless the context clearly indicates otherwise. It will be further understood that the terms "comprises," "comprising," "includes," and/or "including," when used herein, specify the presence of stated features, integers, steps, operations, elements, and/or components, but do not preclude the presence or addition of one or more other features, integers, steps, operations, elements, components, and/or groups thereof.

While aspects of the present disclosure have been particularly shown and described with reference to the embodiments above, it will be understood by those skilled in the art that various additional embodiments may be contemplated by the modification of the disclosed machines, systems and methods without departing from the scope of what is disclosed. Such embodiments should be understood to fall within the scope of the present disclosure as determined based upon the claims.

## Claims

1. A device for use in an audio system including a plurality of amplifier channels of corresponding audio channels, each of the amplifier channels receiving a respective input audio signal and being powered by a same power supply, the device comprising means for performing a method comprising,
- obtaining (810) a value of an indicator, wherein the indicator is representative of an energy reserve of the power supply;
- for each of the amplifier channels, determining (830) a gain to be applied by an attenuation function to the respective input audio signal and a clipping level to be applied by a clipping function to the output of the attenuation function,
wherein the gain decreases over time when the value of the indicator is below a threshold and the gain increases over time up to a maximum value when the value of the indicator is above the threshold, wherein the threshold is representative of a nominal energy level at which the power supply is in nominal operation;
wherein the clipping level is determined as a monotonic function of the value of the indicator.

2. A device according to claim 1, wherein the gain decreases over time by an attack rate.

3. A device according to claim 2, wherein the attack rate is a fixed attack rate that corresponds to a fixed gain decrease per time period on a logarithmic scale.

4. A device according to claim 2, wherein the attack rate is a dynamic attack rate computed as a function of the value of the indicator.

5. A device according to any of claims 1 to 4, wherein the gain increases over time by a release rate.

6. A device according to claim 5, wherein the release rate is a fixed release rate that corresponds to a fixed gain increase per time period on a logarithmic scale.

7. A device according to any of claims 1 to 6, wherein the indicator is proportional to an output voltage of the power supply.

8. A device according to claim 7, wherein, when the value of the indicator is below the threshold, the clipping level is determined as a monotonic function of the output voltage of the power supply.

9. A device according to claim 8, wherein the monotonic function is a continuous function of the output voltage of the power supply.

10. A device according to any of claims 1 to 6, wherein the indicator is proportional to a squared output voltage of the power supply or to a stored energy in the power supply.

11. A device according to claim 1, wherein the gain varies between a minimum value and the maximum value.

12. A device according to claim 1, wherein the monotonic function is adjusted based on mains voltage level signal (350, 450) received from the power supply.

13. A device according to claim 1, wherein the means comprises for each amplifier channel:
- a clipping device connected to the input of the amplifier channel and configured to apply the clipping function;
- an attenuation device whose output is connected to the input of the clipping device, wherein the attenuation device is configured to apply the attenuation function.

14. A method for use in an audio system including a plurality of amplifier channels of corresponding audio channels, each of the amplifier channels receiving a respective input audio signal and being powered by a same power supply, the method comprising,
- obtaining (810) a value of an indicator, wherein the indicator is representative of an energy reserve of the power supply;
- for each of the amplifier channels, determining (830) a gain to be applied by an attenuation function to the respective input audio signal and a clipping level to be applied by a clipping function to the output of the attenuation function,
wherein the gain decreases over time when the value of the indicator is below a threshold and the gain increases over time up to a maximum value when the value of the indicator is above the threshold, wherein the threshold is representative of a nominal energy level at which the power supply is in nominal operation;
wherein the clipping level is determined as a monotonic function of the value of the indicator.

15. A computer program comprising instructions that, when executed by at least one processor, causes a device to perform a method as claimed in claim 14.

## Patentansprüche

1. Vorrichtung zur Verwendung in einem Audiosystem, das eine Vielzahl von Verstärkerkanälen entsprechender Audiokanäle einschließt, wobei jeder der Verstärkerkanäle ein jeweiliges Eingabeaudiosignal empfängt und durch eine gleiche Leistungsversorgung versorgt wird, die Vorrichtung umfassend Mittel zum Durchführen eines Verfahrens, umfassend,
- Erhalten (810) eines Werts eines Indikators, wobei der Indikator repräsentativ für eine Energiereserve der Leistungsversorgung ist;
- für jeden der Verstärkerkanäle, Bestimmen (830) eines Verstärkungsfaktors, der durch eine Dämpfungsfunktion auf das jeweilige Eingabeaudiosignal anzuwenden ist, und eines Begrenzungspegels, der durch eine Begrenzungsfunktion auf die Ausgabe der Dämpfungsfunktion anzuwenden ist, wobei der Verstärkungsfaktor im Laufe der Zeit abnimmt, wenn der Wert des Indikators unter einer Schwelle liegt, und der Verstärkungsfaktor im Laufe der Zeit bis zu einem maximalen Wert zunimmt, wenn der Wert des Indikators über der Schwelle liegt, wobei die Schwelle repräsentativ für einen nominalen Energiepegel ist, bei dem sich die Leistungsversorgung in einem Nennbetrieb befindet;
wobei der Begrenzungspegel als eine monotone Funktion des Werts des Indikators bestimmt wird.

2. Vorrichtung nach Anspruch 1, wobei der Verstärkungsfaktor im Laufe der Zeit mit einer Angriffsrate abnimmt.

3. Vorrichtung nach Anspruch 2, wobei die Angriffsrate eine feste Angriffsrate ist, die einer festen Verstärkungsfaktorabnahme pro Zeitspanne auf einer logarithmischen Skala entspricht.

4. Vorrichtung nach Anspruch 2, wobei die Angriffsrate eine dynamische Angriffsrate ist, die in Abhängigkeit von dem Wert des Indikators berechnet wird.

5. Vorrichtung nach einem der Ansprüche 1 bis 4, wobei der Verstärkungsfaktor im Laufe der Zeit mit einer Freigaberate zunimmt.

6. Vorrichtung nach Anspruch 5, wobei die Freigaberate eine feste Freigaberate ist, die einer festen Verstärkungsfaktorzunahme pro Zeitspanne auf einer logarithmischen Skala entspricht.

7. Vorrichtung nach einem der Ansprüche 1 bis 6, wobei der Indikator proportional zu einer Ausgabespannung der Leistungsversorgung ist.

8. Vorrichtung nach Anspruch 7, wobei, wenn der Wert des Indikators unter der Schwelle liegt, der Begrenzungspegel als eine monotone Funktion der Ausgabespannung der Leistungsversorgung bestimmt wird.

9. Vorrichtung nach Anspruch 8, wobei die monotone Funktion eine stetige Funktion der Ausgabespannung der Leistungsversorgung ist.

10. Vorrichtung nach einem der Ansprüche 1 bis 6, wobei der Indikator proportional zu einer quadrierten Ausgabespannung der Leistungsversorgung oder zu einer gespeicherten Energie in der Leistungsversorgung ist.

11. Vorrichtung nach Anspruch 1, wobei der Verstärkungsfaktor zwischen einem minimalen Wert und dem maximalen Wert variiert.

12. Vorrichtung nach Anspruch 1, wobei die monotone Funktion basierend auf einem Netzspannungspegelsignal (350, 450) angepasst wird, das von der Leistungsversorgung empfangen wird.

13. Vorrichtung nach Anspruch 1, wobei die Mittel für jeden Verstärkerkanal umfassen:
- eine Begrenzungsvorrichtung, die mit der Eingabe des Verstärkerkanals verbunden und konfiguriert ist, um die Begrenzungsfunktion anzuwenden;
- eine Dämpfungsvorrichtung, deren Ausgabe mit der Eingabe der Begrenzungsvorrichtung verbunden ist, wobei die Dämpfungsvorrichtung konfiguriert ist, um die Dämpfungsfunktion anzuwenden.

14. Verfahren zur Verwendung in einem Audiosystem, das eine Vielzahl von Verstärkerkanälen entsprechender Audiokanäle einschließt, wobei jeder der Verstärkerkanäle ein jeweiliges Eingabeaudiosignal empfängt und durch eine gleiche Leistungsversorgung versorgt wird, das Verfahren umfassend,
- Erhalten (810) eines Werts eines Indikators, wobei der Indikator repräsentativ für eine Energiereserve der Leistungsversorgung ist;
- für jeden der Verstärkerkanäle, Bestimmen (830) eines Verstärkungsfaktors, der durch eine Dämpfungsfunktion auf das jeweilige Eingabeaudiosignal anzuwenden ist, und eines Begrenzungspegels, der durch eine Begrenzungsfunktion auf die Ausgabe der Dämpfungsfunktion anzuwenden ist, wobei der Verstärkungsfaktor im Laufe der Zeit abnimmt, wenn der Wert des Indikators unter einer Schwelle liegt, und der Verstärkungsfaktor im Laufe der Zeit bis zu einem maximalen Wert zunimmt, wenn der Wert des Indikators über der Schwelle liegt, wobei die Schwelle repräsentativ für einen nominalen Energiepegel ist, bei dem sich die Leistungsversorgung in einem Nennbetrieb befindet;
wobei der Begrenzungspegel als eine monotone Funktion des Werts des Indikators bestimmt wird.

15. Computerprogramm, umfassend Anweisungen, die, wenn sie durch mindestens einen Prozessor ausgeführt werden, eine Vorrichtung veranlassen, ein Verfahren nach Anspruch 14 durchzuführen.

## Revendications

1. Dispositif destiné à être utilisé dans un système audio comportant une pluralité de canaux d'amplification de canaux audio correspondants, chacun des canaux d'amplification recevant un signal audio d'entrée respectif et étant alimenté par une même alimentation électrique, le dispositif comprenant des moyens de mise en œuvre d'un procédé comprenant,
- une obtention (810) d'une valeur d'un indicateur, dans lequel l'indicateur est représentatif d'une réserve d'énergie de l'alimentation électrique ;
- pour chacun des canaux d'amplificateur, une détermination (830) d'un gain à appliquer par une fonction d'atténuation au signal audio d'entrée respectif et d'un niveau d'écrêtage à appliquer par une fonction d'écrêtage en sortie de la fonction d'atténuation,
dans lequel le gain diminue au fil du temps lorsque la valeur de l'indicateur est inférieure à un seuil et le gain augmente au fil du temps jusqu'à une valeur maximale lorsque la valeur de l'indicateur est supérieure au seuil, dans lequel le seuil est représentatif d'un niveau d'énergie nominal auquel l'alimentation électrique est en fonctionnement nominal ;
dans lequel le niveau d'écrêtage est déterminé en tant que fonction monotone de la valeur de l'indicateur.

2. Dispositif selon la revendication 1, dans lequel le gain diminue au fil du temps avec un taux d'attaque.

3. Dispositif selon la revendication 2, dans lequel le taux d'attaque est un taux d'attaque fixe qui correspond à une diminution de gain fixe par période de temps sur une échelle logarithmique.

4. Dispositif selon la revendication 2, dans lequel le taux d'attaque est un taux d'attaque dynamique calculé en fonction de la valeur de l'indicateur.

5. Dispositif selon l'une quelconque des revendications 1 à 4, dans lequel le gain augmente au fil du temps avec un taux de relâchement.

6. Dispositif selon la revendication 5, dans lequel le taux de relâchement est un taux de relâchement fixe qui correspond à une augmentation de gain fixe par période de temps sur une échelle logarithmique.

7. Dispositif selon l'une quelconque des revendications 1 à 6, dans lequel l'indicateur est proportionnel à une tension de sortie de l'alimentation électrique.

8. Dispositif selon la revendication 7, dans lequel, lorsque la valeur de l'indicateur est inférieure au seuil, le niveau d'écrêtage est déterminé en tant que fonction monotone de la tension de sortie de l'alimentation électrique.

9. Dispositif selon la revendication 8, dans lequel la fonction monotone est une fonction continue de la tension de sortie de l'alimentation électrique.

10. Dispositif selon l'une quelconque des revendications 1 à 6, dans lequel l'indicateur est proportionnel au carré d'une tension de sortie de l'alimentation électrique ou à une énergie stockée dans l'alimentation électrique.

11. Dispositif selon la revendication 1, dans lequel le gain varie entre une valeur minimale et la valeur maximale.

12. Dispositif selon la revendication 1, dans lequel la fonction monotone est réglée en fonction d'un signal de niveau de tension secteur (350, 450) reçu de l'alimentation électrique.

13. Dispositif selon la revendication 1, dans lequel les moyens comprennent pour chaque canal d'amplificateur :
- un dispositif d'écrêtage connecté à l'entrée du canal amplificateur et configuré pour appliquer la fonction d'écrêtage ;
- un dispositif d'atténuation dont la sortie est connectée à l'entrée du dispositif d'écrêtage, dans lequel le dispositif d'atténuation est configuré pour appliquer la fonction d'atténuation.

14. Procédé destiné à être utilisé dans un système audio comportant une pluralité de canaux d'amplification de canaux audio correspondants, chacun des canaux d'amplification recevant un signal audio d'entrée respectif et étant alimenté par une même alimentation électrique, le procédé comprenant,
- une obtention (810) d'une valeur d'un indicateur, dans lequel l'indicateur est représentatif d'une réserve d'énergie de l'alimentation électrique ;
- pour chacun des canaux d'amplificateur, une détermination (830) d'un gain à appliquer par une fonction d'atténuation au signal audio d'entrée respectif et d'un niveau d'écrêtage à appliquer par une fonction d'écrêtage en sortie de la fonction d'atténuation,
dans lequel le gain diminue au fil du temps lorsque la valeur de l'indicateur est inférieure à un seuil et le gain augmente au fil du temps jusqu'à une valeur maximale lorsque la valeur de l'indicateur est supérieure au seuil, dans lequel le seuil est représentatif d'un niveau d'énergie nominal auquel l'alimentation électrique est en fonctionnement nominal ;
dans lequel le niveau d'écrêtage est déterminé en tant que fonction monotone de la valeur de l'indicateur.

15. Programme informatique comprenant des instructions qui, lorsqu'elles sont exécutées par au moins un processeur, amènent un dispositif à mettre en œuvre un procédé selon la revendication 14.
